Europäisches Patentamt

European Patent Office

Office européen des brevets

(19)

(11) EP 0 897 193 A2

(12) **EUROPEAN PATENT APPLICATION**

(43) Date of publication:
17.02.1999 Bulletin 1999/07

(51) Int Cl.$^6$: **H01L 21/768**

(21) Application number: 98305603.7

(22) Date of filing: 14.07.1998

(84) Designated Contracting States:
**AT BE CH CY DE DK ES FI FR GB GR IE IT LI LU MC NL PT SE**
Designated Extension States:
**AL LT LV MK RO SI**

(30) Priority: 14.07.1997 IT RM970431

(71) Applicants:
• **TEXAS INSTRUMENTS INCORPORATED**
  **Dallas Texas 75265 (US)**
  Designated Contracting States:
  **BE CH DE DK ES FI FR GB GR IE IT LI LU MC NL AT**
• **Consorzio Eagle**
  **67051 Avezzano (AQ) (IT)**
  Designated Contracting States:
  **AT BE CH CY DE DK ES FI FR GB GR IE IT LI LU MC NL PT SE**

(72) Inventors:
• **Russo, Felice**
  **67051 Avezzano (IT)**
• **Franchina, Alfredo**
  **67051 Avezzano (IT)**
• **Miccoli, Giuseppe**
  **67051 Avezzano (IT)**
• **Nardi, Natale**
  **67051 Avezzano (IT)**
• **Ricotto, Marco**
  **67051 Avezzano (IT)**

(74) Representative: **Darby, David Thomas et al**
**Abel & Imray,**
**20 Red Lion Street**
**London WC1R 4PQ (GB)**

(54) **Process of making a multilevel metallization scheme with high planarization degree**

(57) Subject-matter of this invention is a method of high planarization multi-level metallization for semiconductor devices in which, starting from a first layer of planarized dielectric material, the interconnection of each level are embedded within a layer of dielectric material.

FIG. 1f

**Description**

This invention broadly relates to a method of high planarization multi-level metallization for semiconductor devices.

More particularly, this invention relates to a method of the above said kind in which the tracks of the various metallization levels are embedded within the layers of dielectric material separating the various metallization levels, starting from a first planar dielectric layer in contact with the substrate of the device, thereby assuring the continuity of the tracks and eliminating the possibility of short circuits between adjacent tracks.

It is known that the manufacture of semiconductor devices comprises a chemical process consisting of a set of steps during which the various components of the specific devices to be manufactured are progressively realized and which is terminated by a final passivation operation of the whole device.

It is also known that the utilization of multi-level metallizations is increasing in order to satisfy the interconnection as well as the circuit layout development requirements of semiconductor electronic devices, particularly in respect of VLSI (Very Large Scale integration) or ULSI (Ultra Large Scale Integration) integrated circuits.

The multi-level interconnection technique, in fact, allows the high contact density requested by circuit miniaturization to be obtained, thereby minimizing the cross-talk and interference and signal delay problems.

In the prior art, a planarization technique of the first dielectric layer, in contact with the substrate of the device, is largely utilized. Such technique is based upon utilization, as dielectric material, of silicon oxides, also known as "Poly Metal Oxide" or "PMO", usually doped with boron and/or phosphorous that, at certain temperatures, become fluid. At first, such PMO is deposited on the surface of the device at low temperature and, consequently, in conforming manner, that is, in such a manner as to follow the shape of the basic surface. It is subsequently subjected to a higher temperature treatment, around 800°C, at which it reflows and is distributed on the surface, in order to planarize it to an extent of about 95%.

The first metallization level is then defined on a metal layer deposited on said PMO layer, having holes manufactured therein, which, upon being filled with said metal, realize the necessary contacts of said first metallization level with the device substrate.

However, such first metallization level introduces a not planar topography caused by the presence of tracks emerging from the planar layer of said PMO.

As the number of the metallization levels increases, the various layers in stacked arrangement introduce an increasingly corrugated topography. In fact, since the maximum allowable temperature value to which the substrate can be subjected decreases as the manufacturing process proceeds, it is no more possible to planarize the surface of the device by utilizing oxides to be caused to reflow.

Due to limitations in the depth of field of the photolithography apparatuses with a resolution lower than one micron, when the height differences of said corrugated topography of the devices to be metallized are higher than a maximum threshold value, which is rather small, the photolithographic techniques applied in patterning the metal layers can fail to properly focus some surface areas of the concerned devices.

This causes a number of drawbacks.

In the first place, the continuity of the metal tracks could be unreliable when they have to surmount high and steep steps, with consequent circuit breaks.

Additionally, after anisotropic chemical etching operations have been carried out, metal residue can remain on the bottom and on the sides of steep steps, with consequent short circuits between the tracks.

In view of the above, it is necessary that the surfaces of the devices be planarized and this planarization can be performed on the layers of dielectric material separating the various metallization levels, even after the definition of the first metallization level.

Various techniques are known to planarize dielectric layers.

A first technique is based upon utilization of a dielectric material, substantially a glass, known under the name "spin-on-glass" or "SOG". Said SOG is a planar material even at relatively low temperatures, but it has the drawback that it should be removed in all those places where the contact holes are to be realized for contact with the metallization layer laid thereupon. This is due to the fact that SOG emits gas when the device is subjected to a vaporization coating, also known as "sputtering", of a metal usually titanium, thereby causing circuit breaks. Aiming at solving this drawback, a reverse chemical corrosion process is performed, the so-called "etch-back", on said SOG layer, but it is, in turn, intrinsically failure affected, due to causes relating to the selectivity of the concerned chemical etch. In view of all above, the technique wherein SOG is used turns out to be extremely complex and expensive. Some aspects of this technique have been described by M. Kawai et al. in "Proceedings 5th Intl. IEEE VMIC Conf.", Santa Clara, CA, page 419, 1988, and by H. Kojima et al.

A second technique is based upon the use of a dielectric material known as "HSQ". Said HSQ material is substantially a silicon oxide dissolved in a solvent and, therefore, it is fluid during deposition. This technique provides for the following steps: a preliminary deposition of a first conforming dielectric layer, consisting of a silicon oxide, also known as "Metal Inter Level Oxide" or "MILO"; a deposition of fluid HSQ, a spreading operation of said HSQ by spinning, in order to planarize the surface of the device; a treatment at about 400°C of the device, in order to dry said HSQ, thereby causing the solvents to vaporize and the material to cure; the deposition of a layer of MILO-2. The contact holes for the underlying metallization level are effected through the above mentioned stack of three dielectric layers. This technique has various drawbacks, as well. In addition to being expensive, because it introduces a set of additional steps into the manufacturing process, this technique also increases the likelihood of producing failure affected devices, thereby lowering the production efficiency. Some aspects of this technique have been described by M. Khan et at. in "Proceedings 2nd Annual IEEE VMIC Conf.", Santa Clara, CA, page 20, 1985.

A third technique is based upon physical-chemical abrasion, also known as "chemical-mechanical polishing", carried out upon the whole worked silicon slice, or "wafer", by means of which the surfaces of the concemed devices are planarized by removing all unevenesses therefrom. Also this technique turns out to be very expensive in economic terms.

Other techniques have also been studied in order to planarize the surfaces of the devices: techniques for reverse chemical corrosion of the dielectric layers, or "dielectric etch-back techniques", as described by A. C. Adams and C.D. Capio in "J. Electroch. Soc.", 128, 423, 1981, and by T. Kobayashi et at., in "Abstract THPM 14.2", page 184, IEEE ISSCC Extended Abstracts, 1982; surface chemical etch planarization by vaporized ions or "surface sputter etch planarization" as described by H. Kotani et at. in "J. Electroch. Soc.", 130, 645, 1983; ion beam surface erosion and planarization as described by L.F. Johnson et at. in "Appl. Phys. Lett. 40", 636, 1982; polyimides as "intermetal dielectric" as described by J.J. Layza and J.L. Wendt in "Ext. Abs. of Electroch. Soc. Meeting", Fall 1986, San Diego, CA, Abs. No. 356; blanket chemical vapor deposition (CVD) and etch-back of W, as described by E.K. Broadbent et at. in "IEEE Trans. Electron. Dev.", July 1988, page 952; selective chemical vapor deposition (CVD) W deposition in the grooves, as described by D.C. Thomas et at. in "Tech. Dig. IEDM", 1988, page 466.

All above mentioned techniques are expensive and entail the introduction of complex working steps into the device manufacturing process.

Having all above in mind, the approach suggested according to his invention is to be considered in order to solve all above mentioned problems.

It is a general object of this invention, therefore, to carry out in simple, reliable and inexpensive manner a multi level metallization for semiconductor devices, such metallization having at each level a high grade of surface planarization, thereby assuring the track continuity and substantially eliminating any short circuit possibility between adjacent tracks.

One aspect of this invention is to carry out said high planarization multi-level metallization without introducing additional process steps to the ones already utilized in conventional manufacturing processes.

Another aspect of this invention Is to provide a method of high planarization multi-level metallization for semiconductor devices which comprises manufacturing a first metallization level, consisting of conductive tracks and contacts to a semiconductor substrate and manufacturing a number of metallization levels subsequent to the first one, also consisting of conductive tracks and of contacts to the underlying metallization level, characterized in that manufacturing the first metallization level includes the following steps:

- a conformal deposition of a first layer of dielectric material upon the whole device to be metallized, said first layer having the capability to reflow at a temperature in the range of 800°C to 900°C as well a suitable thickness preferably equal to the sum of the thickness of the separation dielectric material required between the semiconductor substrate and the interconnection metal tracks and of the thickness required for the Interconnection metal tracks,

- a thermal treatment at said reflow temperature of said dielectric material for a time duration sufficient to planarize the grade higher than 90% and anyway to a grade required by the particular application,

- a first photolithographic process in which, by utilizing a first suitable configuration or "pattern" of photoresponsive resist overposed to said first layer of dielectric material and by selectively chemically etching said first layer of dielectric material, the trenches related to the tracks of the first metallization level of the circuit are defined,

- a second photolithographic process in which, by utilizing a second suitable configuration or "pattern" of photoresponsive resist overposed to said first layer of dielectric material and by subsequently chemically etching said first layer of dielectric material, the holes related to the contacts to the substrate of the first metallization level of the circuit are defined,

- a deposition of a layer of metallic material on the whole device so as to cover said first layer of dielectric material, the deposition technique imparting to said metallic material the capability of uniformly filling any recess and to make the surface as planar as possible,

- a chemical back etch of said layer of metallic material on the whole device so as to again expose the surface of said first layer of dielectric material and realize a high planarization grade, said back etch not being stopped on reaching the surface of said first layer of dielectric material, but being extended for a preestablished time duration as an "over-etch" on the whole surface of the device, and

- a conformal deposition, on the whole device, of a second layer of dielectric material, having a thickness equal to the sum of the of the separation dielectric material required between the metal tracks of two adjacent metallization levels and of the thickness required for the interconnection metal tracks of the subsequent metallization level to be manufactured;

said method being further characterized in that the manufacture of the metallization levels subsequent to the first one comprises the same steps and the same step sequence as for manufacturing the first metallization level, except for the deposition of said first layer of dielectric material and for the thermal treatment at said reflow temperature of said dielectric material, and it is carried out by utilizing in the first and in the second photolithographic process suitable resist patterns corresponding to the metallization level being manufactured.

According to a further aspect of this invention, said suitable thickness of said first layer of dielectric material is equal to the thickness of the required separation dielectric material between the semiconductor substrate and the interconnection metal tracks and manufacturing the first metallization level also includes, after said thermal treatment at said reflow temperature of said dielectric material, a conformal deposition of a third layer of dielectric material on the whole device to be metallized, having a thickness equal to the required thickness for the interconnection metal tracks, and, during said first photolithographic process, the trenches related to the tracks of the first metallization level of the circuit will be defined in the said third layer.

This invention will now be described by way of illustration and not by way of limitation, according to its preferred embodiment, by particularly referring to the Figures of the attached drawings, in which:

Figures 1a-1f are schematic, cross-section, not in scale views of the device surface at the various manufacturing steps of the first metallization level according to this invention.

By referring now to Figure 1a, it can be observed that the first steps of the process to realize the first metallization level provide for depositing a dielectric layer 1 comprising a layer 1' of PMO that, as above described, is caused to reflow in order to planarize the surface of the device, as well as a layer 1" of a further dielectric material, having similar properties to the PMO, consisting of silicon oxide or glass, doped with boron and phosphorous, known as "Boron Phosphorous Silicon Glass" or "BPSG". The thickness of the planar dielectric layer 1" of BPSG should be substantially the same as the thickness required for the interconnection metal tracks, preferably realized of tungsten material.

Figure 1a shows a dielectric layer 1 comprised of PMO and BPSG that, in particular, is utilized in the technology of dynamic random access or DRAM memories. Said layer 1 may be completely formed by BPSG, deposited at a temperature of 430°C by chemical vapor deposition at atmospheric pressure and it is caused to reflow at a temperature of 850°C. This thermal treatment at a temperature of 850°C could also be utilized in order to diffuse and activate the dopant species implanted into the substrate, such as for instance into the drain and/or source regions of the transistors.

By referring now to Figure 1b, it can be observed that the subsequent step of the metallization process is a conventional photolithographic step in which, by utilizing a suitable configuration or "pattern" of photoresponsive resist and a subsequent anisotropic plasma assisted Chemical etch or simply "plasma etch" of the BPSG, the trenches 2 corresponding to the tracks of the first metallization level of the circuit are defined within layer 1" of BPSG. In particular, the chemistry of the plasma assisted etching step for BPSG preferably provides for utilizing trifluoromethane ($CHF_3$) and hexafluoroethane ($C_2F_6$) in order to achieve a highly controlled profile of said trenches 2, thereby achieving nearly vertical side walls. Such control is obtained by polymerizing the ($CF_2$) species, mainly resulting from gaseous trifluoromethane upon the side wall. Preferably, said chemical etching operation is carried out in high pressure conditions in order to obtain a good etching uniformity, with a disuniformity figure lower than 5%, thereby focusing the plasma in the reactor central region.

It should be observed that the photolithographic mask utilized to realized the above mentioned trenches 2 is obtained by reversing the mask utilized for realizing the conventional metallization, having tracks protruding from the oxide and defined upon a metal layer.

In this respect, a further advantage realized by this invention is offered by the fact that the photolithographic process appears to be less critical. In fact, since the interconnection track pattern is no more realized in a metallic surface as it occurs, in contrast, to the prior art, but is realized upon a planar and rather thick dielectric layer, the decrease in light reflectivity of the surface that can generate local defects is no more a problem. This also allows a higher tolerance to be achieved in focusing the surface of the device.

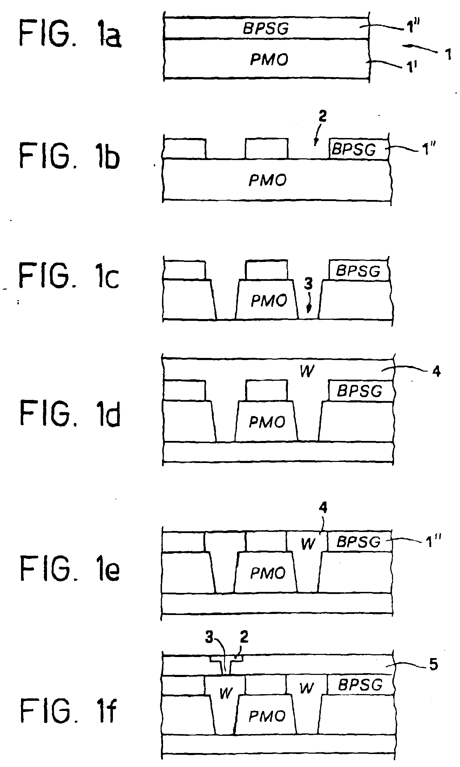

By referring now to Figure 1c, it can be observed that the subsequent step is again a photolithographic step, according to conventional techniques, in which, by utilizing a suitable pattern of photosensitive resist and by means of a subsequent plasma assisted anisotropic chemical etching operation with PMO (or BPSG, when the dielectric layer 1 is totally formed with this material), holes 3 relating to contacts with the substrate of the first metallization level of the circuit are defined in layer 1' of PMO (or BPSG).

Said resist pattern should be realized on a surface in which trenches 2 relating to the tracks of the first metallization level of the circuit have already been defined and said surface is no more a planar surface. This entails a photolithographic process offering more accurate performances in connection with focusing requirements. However, the height differences existing in the surface topography are still comprised in the tolerance limits of the usual photolithographic techniques.

Preferably, the plasma assisted etching operation carried out on layer 1' of PMO (or BPSG) is based upon utilization of trifluoromethane ($CHF_3$) and carbon tetrafluoride ($CF_4$) under argon atmosphere and it is performed at a substrate temperature of -10°C. The substrate temperature enables the profile of the contact hole 3 to be controlled by modifying the adhesion coefficient of the difluoromethilene $\{CF_2\}_n$ polymer. Furthermore, the substrate is preferably equipped with a suitable control system for controlling the temperature distribution in order to obtain a chemical etching having a disuniformity level lower than 5%. The argon atmosphere is utilized to increase the chemical etching speed as well as the plasma etching directionality. By referring now to Figure 1d, it can be observed that the subsequent step comprises performing a vapour phase metal chemical deposition, preferably tungsten (W) upon the whole device, so as to cover the BPSG layer 1". The metal used in this step should be adapted to uniformly fill each and every cavity, the so-called "gap filling" property, in order to form a metal layer 4 having such a thickness as to fill all contact holes 3 as well as the track trenches 2 and such as to make the surface as planar as possible. Particularly in those cases where silicon devices are manufactured and tungsten is used as said metal, the above tungsten deposition operation is preceded by the formation of a thin layer of titanium nitride (TiN) to aid the adhesion and the uniform tungsten nucleation because, as it is known, tungsten does not perfectly adhere to silicon substrates or to silicon dioxide substrates.

Said adherent layer of titanium nitride is preferably obtained by the following step sequence. First of all, a preliminary titanium (Ti) deposition is carried out by ion vaporization or sputtering. The concerned device is subsequently subjected to an annealing operation in horizontal oven at a temperature of 585°C for a time duration of 130 minutes under an atmosphere consisting of 80% nitrogen ($N_2$) and 20% hydrogen ($H_2$). Upon completion of this annealing treatment, the device appears to be provided with a layer of titanium nitride having a variable composition ($TiN_x$) which, after a further annealing treatment at a higher temperature than the previous one, becomes stechiometric titanium nitride ($TiN_2$).

The above noted tungsten deposition is preferably a low pressure chemical vapour deposition (LPCVD) that assures a good conformality to be achieved, in order to obtain completely filled contacts with high height/width ratio, without jeopardizing the desired planarization on large track trenches 2. The deposition process is comprised of three steps: nucleation, contact filling and interconnection.

The nudeation step is a low speed deposition step in which silane ($SiH_4$) is used to chemically reduce the tungsten hexafluoride ($WF_6$). In detail, among the various possible silane reduction reactions, the most likely one is as follows:

$$2WF_6 + 3\,SIH_4 \rightarrow 2W + 3\,SiF_4 \uparrow + 6H_2 \uparrow$$

The object of the nucleation step is to create a first thin layer of tungsten, having a thickness of about 400 Angstrom, acting as a nucleation seed for the subsequent tungsten layer, the deposition of which takes place according to the following hydrogen ($H_2$) reduction reaction:

$$WF_6 + 3H_2 \rightarrow W + 6HF \uparrow$$

When silicon devices are being manufactured, should the hydrogen ($H_2$) reduction reaction be directly exploited on the titanium nitride layer, gaseous tungsten hexafluoride ($WH_6$) could seep into the silicon substrate, thereby generating the following reaction:

$$2\,WF_6 + 3Si \rightarrow 2W + 3SiF_4 \uparrow$$

Such intrusion, that causes the most usual defect known under the term "wormhole", is less likely when the deposition operation begins with silane reduction.

The other two deposition steps are hydrogen ($H_2$) reduction processes.

The second step, which is known as contact filling step, is aimed at filling all contact holes 3 with high height/width ratio, thereby preventing void regions ("voids") being generated.

Lastly, the third step, also known as interconnection step, occurs at the highest deposition speed and guarantees that large trenches 2 are filled with good planarization.

By referring now to Figure 1e, it can be observed that the subsequent step in the manufacturing process of the first metallization level comprises performing a chemical back-etch operation on said metal layer 4, preferably of tungsten, as above mentioned, on the whole surface of the device and, therefore, without any photolithographic pattern, in order to again expose the surface of said dielectric BPSG layer 1" and realize a high planarization figure. In particular, the back-etching action on tungsten is not stopped just when the optical detector indicates that the surface of said dielectric BPSG layer 1" has been reached, but It is continued for a pre-established time duration as a so-called "over-etch", during which any metal residues existing on said surface are removed.

Said reverse or back etching operation is preferably a plasma assisted chemical etch in which sulphur hexafluoride ($SF_6$) and argon (Ar) are used. In this case, the most important parameter is the uniformity of the chemical etch: it should be as high as possible in order to prevent any metal residues from creating short circuit paths between the metal tracks arranged within said trenches 2. The chemical etch rate uniformity is mainly a function of the pressure in the etch chamber, of the reactive gas to inert gas ratio, as well as of the wafer temperature. As a matter of fact, the etch rate is higher in the central area of the wafer when the pressure in the chamber is increasing and, in contrast, the wafer will be more rapidly etched at its edges when the pressure in the chamber is decreasing. This behaviour is due to the fact that a higher pressure in the chamber tends to confine the plasma toward the centre of the chamber, while a lower pressure allows the plasma to uniformly fill the whole volume of the chamber.

Utilization of argon as inert gas provides for a better etch rate uniformity to be obtained with respect to a plasma wholly consisting of sulphur hexafluoride and this uniformity depends on the $SF_6$ / Ar ratio. Furthermore, the temperature of the wafer is a significant factor, in view of the fact that the etch rate is higher in the warmer areas of the concerned wafer: the utilization of a suitable system for controlling the temperature distribution allows a good temperature uniformity and, consequently, a good chemical etch rate uniformity to be obtained on the wafer.

In view of all above, the preferred working course for the chemical back etch of tungsten comprises three steps, namely: etching the bulk tungsten, etching the residuals and etching the adhesion layer.

During the bulk tungsten etching stage, the concerned tungsten is etched by high pressure and high power isotropic plasma, consisting of sulphur hexafluoride ($SF_6$) and argon (Ar).

During the residue etching stage, the concerned tungsten residues are etched by the same chemicals as used in the previous stage, but at lower gaseous flow rate, pressure and power, so as to achieve a high selectivity in respect of the titanium nitride (TiN) layer. This etching step is time controlled.

During the adhesion layer etching stage, which is aimed at removing the titanium nitride (TiN) layer, a plasma consisting of chlorine ($Cl_2$) and argon (Ar) is used. In this step, the selectivity in respect of the tungsten layer is very high in view of the fact that no fluorine compounds are present.

The preferred embodiment of this invention has been described by referring to a tungsten base metallization applied by chemical vapour deposition. It should be understood, however, that it is feasible to utilize also a different metal material, such as aluminium, copper and/or a silicide, deposited by means of any procedure adapted to impart to said metal material the capability to uniformly fill any recess, without so departing from the teachings of this invention.

By referring now to Figure 1f, it can be observed that the last step in the deposition of the first metallization level comprises depositing a dielectric layer 5 upon the whole planar surface of the device, in order to insulate the first metallization level from the subsequent ones. Preferably, said dielectric layer 5 is an oxide layer applied by plasma assisted deposition, at temperatures not higher than 400°C. The above said subsequent metallization levels are realized by repeating the same operation sequence utilized for realizing the first metallization level, starting from definition of trenches 2 in dielectric layer 5 in connection with the tracks of the second metallization level in the circuit and from definition of holes 3 in connection with contacts to the underlying first metallization level, such contacts being designated as "via contacts". As it can be observed, no more high temperature treatment is carried out, like the one needed to obtain PMO reflow in order realize the planar dielectric layer 1'.

The sole metallization level in respect of which it is not necessary that a planar condition be maintained and in which a conventional metallization is acceptable is the last one, in view of the fact that the final passivation layer, also known as "Protective Overcoat" or "PO", does not need photolithographic operations and has no planarization requirements.

In conclusion, with the solution suggested according to this invention, it is possible to realize multilevel metallization semiconductor devices, while the track continuity is assured and the possibility of short circuits between adjacent tracks is eliminated, with high planarization grade, higher than 80% and substantially limited by the planarization grade of the initial dielectric PMO layer 1', which is about 95%. This high planarization grade is obtained by means of an alignment tolerance of the photolithographic masks substantially identical to those required in definition of other circuit components, such as the transistor gates. In addition, the suggested solution has no problem connected with the light reflectivity of a metal layer, which problems are particularly encountered as the device miniaturization advances and consequently the photolithographic resolution requirements increase, in view of the fact that the concerned photolithographic patterns are realized on oxide dielectric layers.

The preferred embodiments of this invention have been described and a number of variations have been suggested hereinbefore, but it should expressly be understood that those skilled in the art can make other variations and changes, without so departing from the scope of this invention as defined by the annexed claims.

## Claims

1. A method of fabricating a high planarization multilevel metallisation for a semiconductor device, which method comprising:

    conformally depositing a first layer (1) of dielectric material over the device to a predetermined thickness such that the material of said first layer is arranged to reflow within a selected temperature range;
    thermally treating said device at said selected temperature range and for a sufficient period to cause said dielectric material (1') to reflow and to planarize said first layer (1);
    forming a first patterned layer over said device and selectively removing regions of said first layer (1) of dielectric material to define trenches (2) related to tracks of a first metallization level; forming a second patterned layer over said device and selectively removing regions of the first layer (1) of dielectric material to define holes related to contacts to the substrate of the first metallization level; depositing a conductive layer (4) over the first layer (1) of dielectric material such that deposited material forms a substantially uniform and planar surface; chemically etching said conductive layer (4) to expose a surface of said first layer of dielectric material and continuing said chemical etching for a predetermined period to over etch the surface of said device; conformally depositing a second layer of dielectric material to a thickness substantially equal to the sum of the thickness of separation dielectric material required between tracks of adjacent metallization levels; repeating the steps of forming the first patterned layer, forming the second patterned layer, depositing the conductive layer, chemically etching the conductive layer, and conformally depositing the second conductive layer.

2. The method as claimed in Claim 1, wherein the step of conformally depositing the first layer of dielectric material comprises conformally depositing the first layer from a dielectric material selected to reflow at a temperature substantially in the range 800-900°C.

3. The method as claimed in Claim 1 or Claim 2, wherein the step of conformally depositing the second layer of dielectric material comprises conformally depositing the second layer substantially at a temperature of less than 450°C.

4. The method as claimed in any of Claims 1 to 3, wherein the step of conformally depositing the first layer of dielectric material comprises conformally depositing the first layer to a thickness substantially equal to the sum of the selected thickness of separation dielectric material between the substrate and interconnection metal tracks and of the selected thickness for the interconnection metal tracks.

5. The method as claimed in any of Claims 1 to 4, wherein the step of conformally depositing the first layer of dielectric material comprises depositing Poly Metal Oxide (PMO) or Boron Phosphorous Silicon Glass (BPSG).

6. The method as claimed in any of Claims 1 to 5 further comprising:

after said step of thermally treating said device, depositing a third layer (1") of dielectric material over the device to a thickness substantially equal to the selected thickness for the interconnection metal tracks such that trenches (2) related to the tracks of the first metallization level are defined in third layer (1") during the step of forming the first patterned layer and selectively removing region of said first layer.

7. The method as claimed in Claim 6, wherein the steps of conformally depositing the first and third layers of dielectric material comprise depositing a first layer of Poly Metal Oxide (PMO) and depositing a third layer of Boron Phosphorous Silicon Glass (BPSG).

8. The method as claimed in any of the preceding claims, wherein each of the steps of removing regions of dielectric material comprise performing an anistropic plasma assisted chemical etch or plasma etch.

9. The method as claimed in any preceding claim, wherein the step of depositing the conductive layer comprises depositing tungsten (W).

10. The method as claimed in Claim 9, wherein the step of depositing the conductive layer of tungsten is preceded by a step of forming a thin layer of titanium nitride (TiN).

11. The method as claimed in Claim 9 or Claim 10, wherein the step of depositing the conductive layer of tungsten comprises performing a low pressure chemical vapour deposition (LPCVD).

12. The method as claimed in any preceding claim, wherein the step of chemically etching said conductive layer comprises performing a highly uniform plasma assisted chemical etch

13. The method as claimed in any preceding claim, wherein the step of conformally depositing the second layer of dielectric material comprises performing a plasma assisted deposition of a layer of oxides substantially at a temperature of less than 400°C.

14. A method of high planarization multi-level metallization for semiconductor devices which comprises forming a first layer comprising conductive tracks and contacts to a semiconductor substrate and forming a plurality of layers subsequent to the first layer, also comprising conductive tracks and of contacts to the underlying metallization level, characterized in that manufacturing the first metallization level includes the following steps:

a conformal deposition of a first layer (1) of dielectric material upon the whole device to be metallized, said first layer having a suitable thickness and the capability to reflow at a temperature in the range of 800°C to 900°C,

a thermal treatment at said reflow temperature of said dielectric material (1') for a time duration sufficient to planarize the deposited layer (1') to the grade required by the particular application,

a first photolithographic process in which, by utilizing a first suitable configuration or "pattern" of photoresponsive resist overposed to said first layer (1) of dielectric material, the trenches (2) related to the tracks of the first metallization level of the circuit are defined,

a second photolithographic process in which, by utilizing a second suitable configuration or "pattern" of photoresponsive resist overposed to said first layer (1) of dielectric material and by subsequently chemically etching said first layer (1) of dielectric material, the holes (3) related to the contacts to the substrate of the first metallization level of the circuit are defined,

a deposition of a layer (4) of metallic material on the whole device so as to cover said first layer (1) of dielectric material, the deposition technique imparting to said metallic material the capability to uniformly fill any recess and to make the surface as planar as possible,

a chemical back etch of said layer (4) of metallic material on the whole device so as to again expose the surface of said first layer (1) of dielectric material and realize a high planarization grade, said back etch being not stopped on reaching the surface of said first layer (1) of dielectric material, but being extended for a pre-established time duration as an "over-etch" on the whole surface of the device, and

a conformal deposition, on the whole device, at a temperature not higher than 450°C, of a second layer (5) of dielectric material, having a thickness equal to the sum of the thickness of the separation dielectric material required between the metal tracks of two adjacent metallization levels and of the metal tracks of two adjacent metallization levels and of the thickness required for the interconnection metal tracks of the subsequent metallization level to be manufactured;

said method being further characterized in that the manufacture of the metallization levels subsequent to the first one comprises the same steps and the same step sequence as for manufacturing the first metallization level, except for the deposition of said first layer of dielectric material and for the thermal treatment at said reflow temperature of said dielectric material, and it is carried out by utilizing in the first and in the second photolithographic process suitable resist patterns corresponding to the metallization level being manufactured.

FIG. 1a

FIG. 1b

FIG. 1c

FIG. 1d

FIG. 1e

FIG. 1f